# FASCICULE DE BREVET EUROPEEN

(11) **EP 0 610 125 B1**
(45) Date de publication et mention de la délivrance du brevet: **19.05.1999**
(21) Numéro de dépôt: 94400202.1
(22) Date de dépôt: 31.01.1994
(51) Int. Cl.: G11B 7/26, B29D 17/00

(54) **Disques maîtres pour la réalisation de matrices de pressage, notamment de disques optiques, et leurs procédés de fabrication**
Urplatten zur Herstellung von Matrizen, insbesondere für optische Platten, und Verfahren zu deren Herstellung
Master disks for producing dies, particularly for optical disks, and their method of manufacture

(30) Priorité: 03.02.1993 FR 9301177
(43) Date de publication de la demande: 10.08.1994
(73) Titulaire: DIGIPRESS, F-14000 Caen (FR)
(72) Inventeur: Ledieu, Jean, F-78121 Crespières (FR); Dufresne, Jean-François, F-14000 Caen (FR)
(74) Mandataire: Beauchamps, Georges

(56) Documents cités:
- EP-A- 0 488 239
- FR-A- 2 542 900
- FR-A- 2 671 657
- PATENT ABSTRACTS OF JAPAN vol. 12, no. 361 (P-763) 28 Septembre 1988 & JP-A-63 112 842 (SEIKO EPSON CORP) 17 Mai 1988
- PATENT ABSTRACTS OF JAPAN vol. 12, no. 144 (P-697) 6 Mai 1988 & JP-A-62 264 461 (VICTOR CO OF JAPAN) 17 Novembre 1987
- DATABASE WPI Section EI, Week 8928, Derwent Publications Ltd., London, GB; Class T03, AN 89-203259 & JP-A-1 142 077 (TOPPAN PRINTING K K) 2 Juin 1989

## Description

L'invention concerne des disques maîtres pour la réalisation de matrices de pressage, notamment de disques optiques. Elle concerne également des procédés pour la fabrication de ces disques maîtres, ainsi que les matrices de pressage obtenues à partir de ces disques maîtres et les disques optiques obtenus à partir de ces matrices de pressage et de ces disques maîtres.

On connaît de nombreux procédés de fabrication de matrices de pressage pour la réalisation de disques optiques. L'un d'entre eux (voir en particulier EP-A-0 488 239) consiste à déposer sur un support en verre une couche de résine photosensible de type positif c'est-à-dire capable sous l'effet d'un rayonnement directif approprié de changer de nature dans les zones recevant ce rayonnement. On soumet cette couche de résine au défilement d'un faisceau laser, venant inscrire dans celle-ci une image latente représentant l'information à enregistrer sur le disque. On développe chimiquement la résine en éliminant par dissolution les zones où la résine a été enregistrée et en réalisant ainsi une succession de microcuvettes correspondant au signal reproduit. Cet état de la technique sert de base au préambule de la revendication 1.

L'ensemble ainsi réalisé constitue un disque maître. Ce disque maître est ensuite revêtu d'une fine couche métallique, notamment en argent, de préférence déposée par évaporation sous vide. Par galvanoplastie on dépose alors une couche de nickel sur le disque maître revêtu de la fine couche métallique. La couche de nickel ainsi formée présente à sa surface des microreliefs qui sont la réplique exacte des microcuvettes précédemment citées, microreliefs représentant en négatif l'information enregistrée sur le disque maître. Après séparation de la couche de nickel du disque maître, la fine couche métallique n'existe plus lors de la séparation. On obtient ainsi une matrice d'impression en nickel qui permettra de réaliser, par pressage d'une matière plastique appropriée, notamment du polycarbonate, les disques à lecture optique souhaités. Après la séparation de la matrice du disque maître ainsi obtenu, celui-ci est détruit.

En outre, ce disque maître n'est pas lisible dans un lecteur de disques optiques.

La présente invention a pour objet de pallier les inconvénients précédents en proposant des disques maîtres lisibles par un lecteur de disques optiques et pouvant être utilisés autant de fois que nécessaire pour la réalisation de nouvelles matrices, et ce sans traitement ultérieur. A cet effet, l'invention propose un disque maître pour la réalisation d'une matrice de pressage, notamment de disques optiques, du type constitué d'un support (1) portant à sa surface une succession de microcuvettes représentatives de l'information à dupliquer, caractérisé en ce que ladite succession de microcuvettes est constituée d'un matériau (9) dur, réfléchissant dans le proche infrarouge et conducteur choisi parmi un nitrure ou un carbonitrure de zirconium, d'hafnium ou de titane, une céramique dure réfléchissante dans le proche infrarouge et conductrice seulement en surface et un verre dur, réfléchissant dans le proche infrarouge et conducteur seulement en surface et en ce ledit disque maître est constitué d'au plus deux matériaux.

Selon une caractéristique de ce disque maître, le support est en aluminium.

Selon une autre caractéristique du disque maître de l'invention, le support est en verre trempé et/ou désalcalinisé.

Selon un mode de réalisation particulier de l'invention, la succession de microcuvettes représentatives de l'information est constituée du matériau (9) dur, conducteur et réfléchissant dans le proche infrarouge seulement en surface.

Selon un autre mode de réalisation particulier de l'invention, le support du disque maître est constitué du même matériau (9) que la succession de microcuvettes.

Selon une particularité des disques maîtres de l'invention le matériau dur, réfléchissant dans le proche infrarouge et conducteur est du nitrure de titane.

Selon d'autres particularités des disques maîtres de l'invention, la profondeur des microcuvettes est comprise entre environ 500 et environ 2000Å, l'épaisseur totale du disque maître est comprise entre environ 1 et environ 5 mm et le disque maître a un diamètre compris entre environ 150 mm et environ 200 mm.

L'invention propose également des procédés de fabrications de tels disques maîtres ainsi que des utilisations tels que définis dans les revendications jointes.

D'autres caractéristiques, détails et avantages de l'invention apparaîtront plus clairement dans la description détaillée qui suit et qui se réfère aux figures annexées dans lesquelles :

La figure 1 illustre schématiquement un premier mode de réalisation du disque maître de l'invention.

La figure 2 illustre schématiquement un second mode de réalisation des disques maîtres de l'invention.

La figure 3 illustre schématiquement un troisième mode de réalisation des disques maîtres de l'invention.

Dans tous les cas, les disques maîtres de l'invention sont constitués d'un support comportant à sa surface une succession de microcuvettes représentatives de l'information à dupliquer constituée, au moins en surface, d'un matériau 9 dur, réfléchissant dans le proche infrarouge et conducteur.

Ce matériau 9 devra être très dur et ne pas se rayer facilement de façon à pouvoir être manipulé aisément et avoir une grande longévité sur le plan mécanique pour pouvoir permettre la fabrication de nombreuses matrices sans que ces fabrications répétées ne modifient la forme des microcuvettes ni leur profondeur. Il devra avoir une très bonne adhérence sur le substrat, en particulier sur le verre et encore plus particulièrement sur l'aluminium de façon à éliminer tout risque d'arrachage lors de l'étape ultérieure de galvanoplastie qui conduira à l'obtention de la matrice de pressage. Il devra être conducteur pour permettre l'étape de galvanoplastie. Il devra également être stable chimiquement de façon à résister dans les bains chimiques et avoir une grande longévité dans les environnements difficiles et enfin il devra réfléchir dans le domaine des longueurs d'onde utilisées par les lecteurs de disques optiques c'est-à-dire dans le proche infrarouge, plus précisément à des longueurs d'onde d'environ 780 nm.

A cet égard, le matériau 9 sera choisi parmi un nitrure ou un carbonitrure de zirconium, d'hafnium ou de titane, ou une céramique dure, réfléchissant dans le proche infrarouge et conductrice.

Les disques maîtres de l'invention présentent de nombreux avantages sur les disques maîtres connus jusqu'à présent. Tout d'abord ils permettront la fabrication de nombreuses matrices de pressage sans risque de détérioration et de modification de l'information qu'ils contiennent et sans traitement préalable. Ensuite, il n'est pas nécessaire de leur faire subir une préparation spéciale avant d'effectuer l'étape de fabrication de la matrice par galvanoplastie. Enfin, les informations qu'ils contiennent pourront être lues directement dans un lecteur de disques optiques. Toutes ces propriétés combinées permettront de l'utiliser, de plus, dans un but d'archivage à longue durée d'informations.

Pour mieux faire comprendre l'objet de l'invention, on va en décrire maintenant à titre d'exemples purement illustratifs et non limitatifs plusieurs modes de réalisations.

### EXEMPLE 1

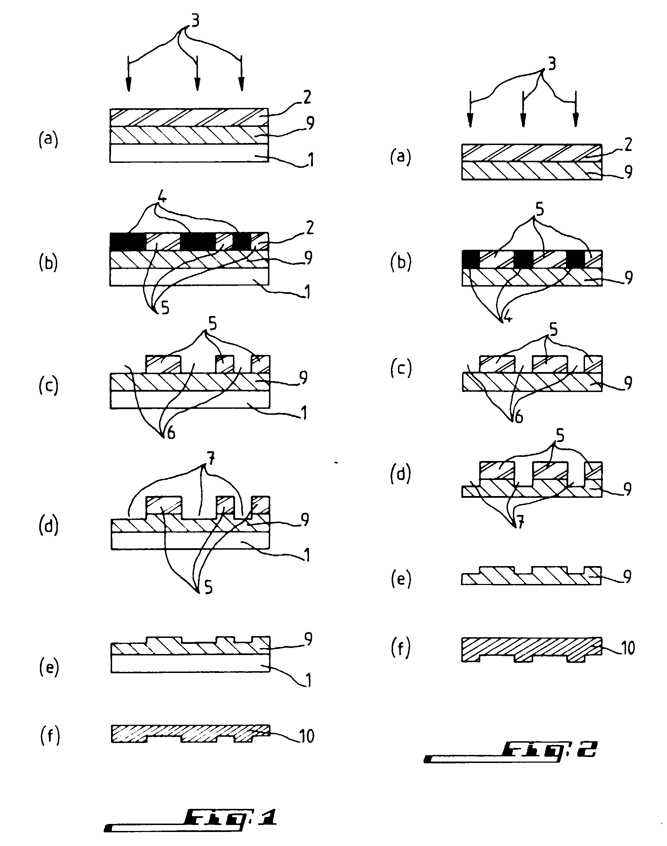

En se référant à la figure 1, la première étape notée (a) de ce mode de réalisation préféré de l'invention consiste à déposer sur un substrat 1 en verre désalcalinisé et/ou trempé, une couche du matériau 9 dur, réfléchissant dans le proche infrarouge et conducteur, de préférence du nitrure de titane. L'épaisseur de cette couche de matériau 9 devra être supérieure à la profondeur des microcuvettes à former. La profondeur de ces microcuvettes doit être comprise entre environ 500 et environ 2000Å pour être lisibles dans les lecteurs de disques optiques actuels. Cette profondeur sera de préférence de 1500Å.

L'épaisseur finale du disque maître obtenu devra être comprise entre environ 1 et environ 5 mm, de préférence entre environ 1 et environ 3 mm, pour être lisible dans les lecteurs de disques optiques, ce qui signifie que l'épaisseur du support 1 sera comprise entre environ 1 et environ 5 mm, de préférence entre environ 1 et environ 3 mm et, toujours pour permettre la lecture du disque maître obtenu en final dans les lecteurs de disques optiques actuels et pour permettre l'utilisation d'un procédé de galvanoplastie simple pour fabriquer la matrice à partir de ce disque maître, le diamètre de ce substrat 1 sera compris entre environ 150 mm et environ 200 mm. La couche de matériau 9 est ensuite recouverte d'une couche 2 de résine photosensible et l'information à dupliquer est enregistrée dans cette couche 2 de résine photosensible sous forme d'une image latente créée par défilement d'un faisceau lumineux 3 modulé en fonction du signal à encoder, ce faisceau lumineux 3 étant de préférence un faisceau laser.

Après cet enregistrement, comme illustré à l'étape notée (b) dans la figure 1, la couche 2 de résine photosensible comporte alors des zones 4 insolées de résine photosensible et des zones 5 non insolées de résine photosensible.

A l'étape (c) on élimine, par dissolution chimique ou par tout autre procédé approprié les zones 4 insolées de résine. On a ainsi créé des microcuvettes 6 dans la couche 2 de résine photosensible, représentatives de l'information à dupliquer.

A l'étape suivante notée (d) l'information à dupliquer est transférée dans les zones 7 de la couche de matériau 9, qui ne sont plus recouvertes de la résine photosensible par un procédé de gravure chimique, ou par un procédé de gravure par plasma réactif.

Enfin, les zones 5 de résine photosensible non insolées et résiduelles sont éliminées de préférence par plasma à oxygène et l'on obtient le disque maître désiré et illustré en (e) constitué du substrat 1, recouvert de microcuvettes en matériau 9, de préférence en nitrure de titane.

Le disque maître ainsi obtenu permet la fabrication de la matrice de pressage 10, représentée en (f) par une étape de galvanoplastie ultérieure, sans nécessité de préparation spécifique.

Après cette étape de galvanoplastie, le disque maître pourra être réutilisé de nombreuses fois pour la réalisation future de nouvelles matrices, il pourra être lu dans les lecteurs de disques traditionnels et donc être testé dans les lecteurs de disques compacts adaptés et il pourra servir comme archive d'informations.

Un avantage supplémentaire de ce mode de réalisation est que l'on pourra préparer d'avance le substrat 1 recouvert de la couche de matériau 9, dur, réfléchissant dans le proche infrarouge et conducteur, ce qui permettra de ne pas intégrer l'étape de dépôt de la couche de matériau 9 dans le procédé de fabrication du disque maître et de la matrice.

### EXEMPLE 2

Dans cet exemple, on réalise le disque maître comme à l'exemple 1 sauf que le substrat 1 est en aluminium. L'aluminium présente l'avantage sur le verre d'être moins fragile, tout en permettant, comme dans le cas du verre, d'obtenir un état de surface compatible avec la fabrication de disques maîtres, de matrices de pressage et de disques optiques, c'est-à-dire une surface ne comportant pas de rugosité supérieure à 50Å.

Un autre avantage de l'utilisation d'un substrat 1 en aluminium est un avantage d'ordre économique, l'aluminium étant un matériau moins cher que le verre.

Bien entendu, comme à l'exemple 1, on pourra préparer d'avance le substrat 1 en aluminium recouvert d'une couche de nitrure de titane, ce qui permettra également de ne pas intégrer cette étape de dépôt dans le procédé de fabrication du disque maître et de la matrice de pressage.

Ainsi, le disque maître obtenu selon le mode de réalisation de l'exemple 1 et constitué d'un substrat 1 en aluminium recouvert d'une succession de microcuvettes, représentatives de l'information à dupliquer, constituée de nitrure de titane est le mode de réalisation le plus préféré de l'invention.

### EXEMPLE 3

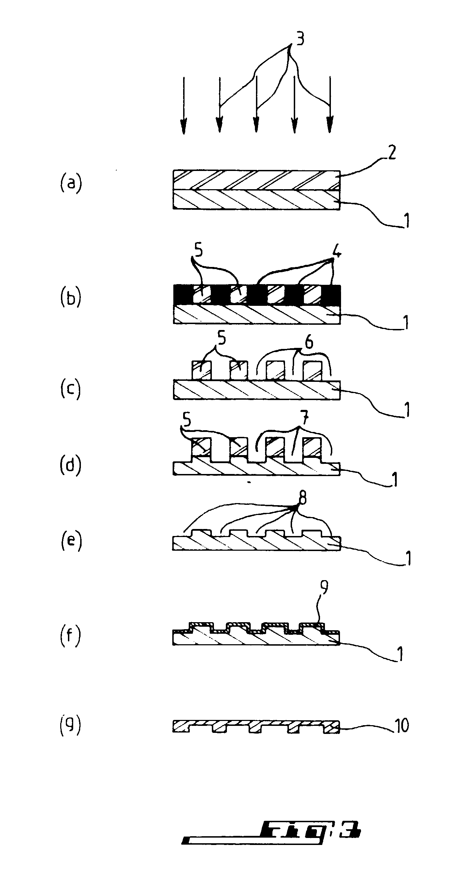

En se référant maintenant à la figure 2, on décrira un procédé exemplaire de fabrication d'un disque maître selon l'invention, dans lequel les microcuvettes représentatives de l'information et le substrat sont constitués du même matériau 9 dur, réfléchissant dans le proche infrarouge et conducteur. Comme illustré à l'étape notée (a) en figure 2, la première étape de ce procédé consiste à déposer sur le substrat constitué du matériau 9, une couche 2 de résine photosensible dans laquelle l'information à dupliquer est enregistrée par défilement d'un faisceau laser 3 modulé en fonction du signal à encoder.

Les dimensions du substrat en matériau 9 seront identiques à celles citées à l'exemple 1.

Comme illustré à l'étape notée (b) dans la figure 2, le support en matériau 9 comporte alors des zones 4 insolées de résine photosensible et des zones 5 non insolées de résine photosensible.

L'étape notée (c) dans la figure 2 est une étape d'élimination, par dissolution chimique ou par tout autre procédé approprié, des zones 4 insolées de résine, ce qui amène à la création dans la couche 2 de résine photosensible de microcuvettes 6.

A l'étape notée (d) dans la figure 2, on procède au transfert de l'information enregistrée dans les zones 7 du support en matériau 9 qui ne sont plus recouvertes par la résine photosensible, par un procédé de gravure chimique, ou par un procédé de gravure par plasma réactif.

Les zones 5 de résine résiduelle sont ensuite éliminées par plasma à oxygène et l'on obtient alors le disque maître désiré, représenté à l'étape notée (e) dans la figure 2, constitué d'un support 1 comportant à sa surface une succession de microcuvettes dont la profondeur correspond à la profondeur de la gravure précédemment effectuée, le substrat et les microcuvettes étant constitués du même matériau 9.

Dans les modes de réalisation décrits aux exemples 1, 2 et 3, on pourra également utiliser, en tant que matériau 9, un matériau dur, réfléchissant dans le proche infrarouge et conducteur seulement en surface, tel qu'un verre conducteur ou une céramique conductrice.

### EXEMPLE 4

Un autre procédé exemplaire de fabrication d'un disque maître selon l'invention est illustré schématiquement en figure 3.

Ce procédé consiste à déposer sur un support 1 en verre une couche 2 d'une substance photosensible. Ce support en verre sera préférentiellement un disque d'une épaisseur d'environ 1,2 mm, épaisseur standard d'un disque compact, et aura un diamètre permettant d'une part la lecture dans les lecteurs de disques optiques traditionnels, et d'autre part, permettant l'utilisation d'un procédé de galvanoplastie simple. Pour des raisons de standardisation de machines, ce diamètre sera de préférence compris entre environ 150 mm et environ 200 mm.

Ce support pourra également être constitué d'un verre trempé et/ou désalcalinisé ou d'aluminium.

Dans une première étape notée (a) à la figure 3, l'information à dupliquer est enregistrée sur ce support 1 sous forme d'une image latente créée par un faisceau lumineux 3 modulé en fonction du signal à encoder, ce faisceau lumineux 3 étant de préférence un faisceau laser.

Comme illustré à l'étape notée (b) dans la figure 3, le support 1 en verre comporte des zones 4 de résine photosensible insolées et des zones 5 de résine photosensible non insolées.

L'étape (c) est une étape d'élimination par dissolution chimique ou par tout autre procédé approprié, des zones de résines insolées.

On obtient à ce stade le support 1 en verre comportant à sa surface une succession de microcuvettes 6.

A l'étape suivante notée (d), on procède au transfert de l'information à enregistrer dans les zones 7 du support en verre par un procédé de gravure chimique ou par un procédé de gravure par plasma réactif, de préférence par un procédé de gravure par plasma réactif d'ions argon et d'ions fluor, les ions fluor étant obtenus par utilisation de trifluorométhane gazeux.

La résine résiduelle est ensuite éliminée de préférence par plasma à oxygène et l'on obtient dans le disque maître désiré constitué du support 1 en verre, représenté en (e) dans la figure 3, et comportant à sa surface une succession de microcuvettes dont la profondeur correspond à la profondeur de la gravure précédemment effectuée.

Cette succession de microcuvettes est ensuite revêtue d'une couche du matériau 9. Le matériau 9 est déposé de préférence par pulvérisation cathodique réactive avec magnétron. Les gaz utilisés dans le cas du dépôt de nitrure de titane sont l'argon, nécessaire au bombardement de la cible de titane et, l'azote, nécessaire à la formation du nitrure. Un contrôle très précis de la pression partielle des gaz dans la chambre est nécessaire pour obtenir une bonne stoechiométrie.

L'épaisseur déposée sera comprise entre environ 500Å et 1400Å. Elle sera de préférence égale à 1100Å.

Le disque maître ainsi obtenu représenté en (f) est constitué du support en verre 1 portant à sa surface une succession de microcuvettes 8 dont la surface est constituée du matériau 9.

Par une étape de galvanoplastie, à partir de ce disque maître, on obtient la matrice 10 représentée en (g).

Comme aux exemples 1, 2 et 3 ci-dessus, le disque maître permettra la fabrication d'une matrice par une étape de galvanoplastie, sans nécessiter de préparation spécifique. Il pourra être lu par les lecteurs de disques traditionnels et par là même il pourra être testé dans les testeurs de disques compacts adaptés. En raison de cette très grande longévité, il peut ainsi être utilisé comme archive d'informations ou pour la réalisation future de nouvelles matrices destinées au pressage de disques optiques. De plus on peut le stocker aisément du fait de ses dimensions.

Un intérêt important des disques maîtres de l'invention est que, lors de l'étape de fabrication de la matrice, il n'y a pas d'arrachement ou de séparation de la couche de matériau dur, réfléchissant dans le proche infrarouge et conducteur du disque maître, lors de la séparation du disque de la matrice fabriquée, ce qui permet de ne pas avoir à redéposer de nouvelle couche conductrice lors de la fabrication ultérieure de nouvelles matrices.

Et du fait de cette conservation de l'intégrité des disques maîtres de l'invention, les informations qu'ils contiennent ne sont pas détériorées ou modifiées.

Bien entendu l'invention n'est nullement limitée aux modes de réalisation décrits et illustrés qui n'ont été donnés qu'à titre d'exemples.

Ainsi, le support pourra, lorsqu'il n'est pas constitué du même matériau que les microcuvettes, être constitué de tout autre matériau que le verre et l'aluminium cités ici à condition de permettre l'obtention de surface voulu et de permettre l'adhérence du matériau 9 dur, réfléchissant dans le proche infrarouge et conducteur.

Egalement, tout autre matériau 9 dur, réfléchissant dans le proche infrarouge et conducteur, différent de ceux cités ici pourra être employé.

## Revendications

1. Disque maître pour la réalisation d'une matrice de pressage, notamment de disques optiques, du type constitué d'un support (1) portant à sa surface une succession de microcuvettes représentatives de l'information à dupliquer, caractérisé en ce que ladite succession de microcuvettes est constituée d'un matériau (9) dur, réfléchissant dans le proche infrarouge et conducteur choisi parmi un nitrure ou un carbonitrure de zirconium, d'hafnium ou de titane, une céramique dure réfléchissante dans le proche infrarouge et conductrice seulement en surface et un verre dur, réfléchissant dans le proche infrarouge et conducteur seulement en surface et en ce ledit disque maître est constitué d'au plus deux matériaux.

2. Disque maître selon la revendication 1, caractérisé en ce que le support (1) est en aluminium.

3. Disque maître selon la revendication 1, caractérisé en ce que le support (1) est en verre trempé et/ou désalcalinisé.

4. Disque maître selon l'une quelconque des revendications précédentes, caractérisé en ce que ladite succession de microcuvettes est constituée seulement en surface dudit matériau (9).

5. Disque maître selon la revendication 1, caractérisé en ce que le support (1) est constitué du même matériau (9) que la succession de microcuvettes.

6. Disque maître selon l'une quelconque des revendications précédentes, caractérisé en ce que le matériau (9) est du nitrure de titane.

7. Disque maître selon l'une quelconque des revendications précédentes, caractérisé en ce que la profondeur des microcuvettes est comprise entre environ 500 et environ 2000 Å, l'épaisseur totale du disque maître est comprise entre environ 1 et environ 5 mm et en ce que le diamètre du disque maître est compris entre environ 150 mm et environ 200 mm.

8. Procédé de fabrication d'un disque maître selon la revendication 2 ou la revendication 3, le procédé comprenant les étapes successives de :
- dépôt sur un support (1) d'une couche de matériau (9);
- dépôt sur la couche de matériau (9) d'une couche de résine photosensible (2);
- enregistrement de l'information à dupliquer dans la couche de résine photosensible (2) sous forme d'image latente par défilement d'un faisceau lumineux (3) modulé en fonction du signal à enregistrer;
- élimination des zones (4) de résine photosensible insolées, cette élimination menant à la création d'une succession de microcuvettes (6) dans ladite couche de résine photosensible,
- transfert de l'information dans la couche de matériau (9), ce transfert menant à la création d'une succession de microcuvettes (7) dans la couche de matériau (9); et
- élimination des zones (5) de résine résiduelle après ce transfert.

9. Procédé de fabrication d'un disque maître selon la revendication 5, le procédé comprenant les étapes successives de :
- dépôt sur un support (1) composé du matériau (9) d'une couche de résine photosensible (2);
- enregistrement de l'information à dupliquer dans la couche de résine photosensible (2) sous forme d'image latente par défilement d'un faisceau lumineux (3) modulé en fonction du signal à enregistrer;
- élimination des zones (4) de résine insolées, cette élimination menant à la création d'une succession de microcuvettes (6) dans la couche de résine photosensible (2);
- transfert de l'information dans le support (1), ce transfert menant à la création de microcuvettes (7) dans le substrat (1); et
- élimination des zones (4) de résine photosensible résiduelle.

10. Procédé de fabrication d'un disque maître selon la revendication 4, le procédé comprenant les étapes successives de
- dépôt sur un support (1) d'une couche (2) de résine photosensible;
- enregistrement de l'information à dupliquer sous forme d'image latente, dans la couche de résine photosensible (2) par défilement d'un faisceau lumineux (3) modulé en fonction de l'information à enregistrer;
- élimination de la résine photosensible dans les zones (4) insolées, cette élimination menant à la création d'une succession de microcuvettes (6) dans la couche (2);
- transfert de l'information dans le support (1), ce transfert menant à la création de microcuvettes (7) dans le substrat (1);
- élimination des zones (5) de résine résiduelle; et
- dépôt d'une couche de matériau (9) sur la surface du support (1) comportant la succession de microcuvettes.

11. Procédé selon l'une quelconque des revendications 8 à 10, caractérisé en ce que la matériau (9) est du nitrure de titane.

12. Procédé selon l'une quelconque des revendications 8 à 11, caractérisé en ce que le faisceau lumineux (3) est un faisceau laser, l'élimination de la substance photosensible (2) est réalisée par attaque chimique ou par attaque par plasma à oxygène, et en ce que le transfert de l'information s'effectue par un procédé de gravure chimique ou par un procédé de gravure par plasma réactif.

13. Utilisation du disque maître selon l'une quelconque des revendications 1 à 7 et/ou obtenu selon le procédé selon l'une des revendications 8 à 12 pour la fabrication d'une matrice de pressage de disques optiques.

## Claims

1. Master disc for making a die in particular for pressing optical discs, of the type consisting of a support (1) carrying at its surface a series of micropits representative of the information to be duplicated, characterized in that the said series of micropits consists of a hard material (9) reflecting in the near infrared and being conductive, selected among a nitride or a carbonitride of zirconium, of hafnium or of titanium, a hard ceramic reflecting in the near infrared and being conducting at the surface only and a hard glass reflecting in the near infrared and being conductive at the surface only and in that the said master disc consists at most of two materials.

2. Master disc according to claim 1, characterized in that the support (1) is of aluminium.

3. Master disc according to claim 1, characterized in that the support (1) is of tempered and/or dealkalinized glass.

4. Master disc according to any one of the foregoing claims, characterized in that the said series of micropits is formed at the surface only of the said material (9).

5. Master disc according to claim 1, characterized in that the support (1) consists of the same material (9) as the series of micropits.

6. Master disc according to any one of the foregoing claims, characterized in that the material (9) is titanium nitride.

7. Master disc according to any one of the foregoing claims, characterized in that the depth of the micropits is comprised between about 500 and about 2,000 Å, the total thickness of the master disc is comprised between about 1 and about 5 mm and in that the diameter of the master disc is comprised between about 150 mm and about 200 mm.

8. Method of manufacture of a master disc according to claim 2 or claim 3, the method comprising the successive steps of:
- depositing a layer of material (9) upon a support (1);
- depositing a layer of photosensitive resin (2) upon the layer of material (9);
- recording the information to be duplicated into the layer of photosensitive resin (2) as a latent image by the travel of a light beam (3) modulated in accordance with the signal to be recorded ;
- removing the insolated zones (4) of photosensitive resin, this removal leading to the creation of a series of micropits (6) in the said layer of photosensitive resin ;
- transferring the information into the layer of material (9), this transfer leading to the creation of a series of micropits (7) in the layer of material (9); and
- removing the zones (5) of residual resin after this transfer.

9. Method of manufacture of a master disc according to claim 5, the method comprising the successive steps of:
- depositing a layer of photosensitive resin (2) upon a support (1) consisting of the material (9);
- recording the information to be duplicated into the layer of photosensitive resin (2) as a latent image by the travel of a light beam (3) modulated in accordance with the signal to be recorded ;
- removing the insolated zones (4) of resin, this removal resulting in the creation of a series of micropits (6) in the layer of photosensitive resin (2);
- transferring the information into the support (1), this transfer resulting in the creation of micropits (7) in the substrate (1); and
- removing the zones (4) of residual photosensitive resin.

10. Method of manufacture of a master disc according to claim 4, the method comprising the successive steps of:
- depositing a layer (2) of photosensitive resin upon a support (1);
- recording the information to be duplicated as a latent image into the layer of photosensitive resin (2) by the travel of a light beam (3) modulated in accordance with the information to be recorded ;
- removing the photosensitive resin in the insolated zones (4) , this removal leading to the creation of a series of micropits (6) in the layer (2);
- transferring the information into the support (1), this transfer leading to the creation of micropits (7) in the substrate (1);
- removing the zones (5) of residual resin ; and
- depositing a layer of material (9) upon the surface of the support (1) comprising the series of micropits.

11. Method according to any one of claims 8 to 10, characterized in that the material (9) is titanium nitride.

12. Method according to any one of claims 8 to 11, characterized in that the light beam (3) is a laser beam, the removal of the photosensitive substance (2) is carried out by chemical etching or by oxygen plasma attack and in that the transfer of the information is effected by a process of chemical engraving or by a process of engraving with a reactive plasma.

13. Utilization of the master disc according to any one of claims 1 to 7 and/or obtained with the method according to one of claims 8 to 12 for the manufacture of a die for pressing optical discs.

## Patentansprüche

1. Urplatte für die Herstellung einer Matrize zur Prägung insbesondere von optischen Platten, der aus einer an ihrer Fläche eine Reihenfolge von die zu duplizierende Information darstellenden Mikrovertiefungen tragenden Tragauflage (1) bestehenden Gattung, dadurch gekennzeichnet, daß die besagte Reihenfolge von Mikrovertiefungen aus einem harten, in dem nahen Infraroten Bereich zurückstrahlenden und leitenden Werkstoff (9) besteht, der unter einem Zirkonium-, Hafnium- oder Titannitrid oder-karbonitrid, einer harten in dem nahen Infrarotbereich zurückstrahlenden und nur an der Oberfläche leitenden Keramik und einem harten, in dem nahen Infrarotbereich zurückstrahlenden und nur an der Oberfläche leitenden Glas gewählt wird, besteht und daß die besagte Urplatte aus höchstens zwei Werkstoffen besteht.

2. Urplatte gemäß Anspruch 1, dadurch gekennzeichnet, daß die Tragauflage (1) aus Aluminium besteht.

3. Urplatte nach Anspruch 1, dadurch gekennzeichnet, daß die Tragauflage (1) aus hartem und/oder entalkalinisiertem Glas besteht.

4. Urplatte gemäß irgendeinem der vorangehenden Ansprüche, dadurch gekennzeichnet, daß die besagte Reihenfolge von Mikrovertiefungen nur an der Oberfläche des besagten Werkstoffes (9) gebildet ist.

5. Urplatte nach Anspruch 1, dadurch gekennzeichnet, daß die Tragauflage (1) aus dem selben Werkstoff (9), wie die Reihenfolge von MiKrovertiefungen besteht.

6. Urplatte gemäß irgendeinem der vorangehenden Ansprüche, dadurch gekennzeichnet, daß der Werkstoff (9) Titannitrid ist.

7. Urplatte nach irgendeinem der vorangehenden Ansprüche, dadurch gekennzeichet daß die Tiefe der Mikrovertiefungen zwischen ungefähr 500 und ungefähr 2000 Å liegt, die Gesamtdicke der Urplatte zwischen ungefähr 1 und ungefähr 5 mm liegt und daß der Durchmesser der Urplatte zwischen ungefähr 150 mm und ungefähr 200 mm liegt.

8. Verfahren zur Herstellung einer Urplatte gemäß Anspruch 2 oder Anspruch 3, wobei das Verfahren die aufeinanderfolgenden Schritte :
- eines Auftragens einer Werkstoffschicht (9) auf einer Tragauflage (1);
- eines Auftragens einer Schicht aus lichtempfindlichem Harz (2) auf der Werkstoffschicht (9) ;
- einer Aufzeichnung der zu duplizierenden Information in der Schicht aus lichtempfindlichem Harz (2) als latentes Bild durch Vorbeifahren eines in Abhängikeit des aufzuzeichnenden Signals modulierten Lichtstrahlenbündels (3);
- einer Beseitigung der bestrahlten Bereiche (4) aus lichtempfindlinchem Harz, wobei diese Beseitigung zu der Schaffung einer Reihenfolge von Microvertiefungen (6) in der besagten Schicht aus lichtempfindlichem Harz führt;
- einer Übertragung der Information in die Werkstoffschicht (9), wobei diese Übertragung zu der Schaffung einer Reihenfolge von Mikrovertiefungen (7) in der Werkstoffschicht (9) führt ; und
- einer Beseitigung der Bereiche (5) des Restharzes nach dieser Übertragung,
umfaßt.

9. Verfahren zur Herstellung einer Urplatte gemäß Anspruch 5, wobei das Verfahren die aufeinanderfolgenden Schritte :
- eines Auftrags einer Schicht aus lichtempfindlichem Harz (2) auf einer sich aus dem Werkstoff (9) zusammensetzenden Tragauflage (1);
- einer Aufzeichnung der zu duplizierenden Information in der Schicht aus lichtempfindlichem Harz (2) als latentes Bild durch Vorbeifahren eines in Abhängigkeit des aufzuzeichnenden Signals modulierten Lichtstrahlenbündels (3);
- einer Beseitigung der bestrahlten Harzbereiche (4), wobei diese Beseitigung zu der Schaffung einer Reihenfolge von Mikrovertiefungen (6) in der Schicht aus lichtempfindlichem Harz (2) führt ;
- einer Übertragung der Information in die Tragauflage (1), wobei diese Übertragung zu der Schaffung von Mikrovertiefungen (7) in dem Substrat (1) führt ;und
- einer Beseitigung der Bereiche (4) aus restlichem Lichtempfindlichem Harz ;
umfaßt

10. Verfahren zur Herstellung einer Urplatte nach Anspruch 4, wobei das Verfahren die aufeinanderfolgenden Schritte :
- eines Auftrags einer Schicht (2) auf Lichtempfindlichem Harz auf einer Tragauflage (1) ;
- einer Aufzeichnung der zu duplizierenden Information als latentes Bild in der Schicht aus Lichtempfindlichem Harz (2) durch Vorbeifahren eines in Abhängigkeit der aufzuzeichnenden Information modulierten Lichtstrahlenbündels (3);
- einer Beseitigung des Lichtempfindlichem Harzes in den bestrahlten Bereichen (4), wobei diese Beseitigung zu der Schaffung einer Reihenfolge von Mikrovertiefungen (6) in der Schicht (2) führt ;
- eine Übertragung der Information in die Tragauflage (1), wobei diese Übertragung zu der Schaffung von Mikrovertiefungen (7) in dem Substrat (1) führt ;
- einer Beseitigung der Restharzbereiche (5) ; und
- eines Auftragens einer Werkstoffschicht (9) auf die Oberfläche der die Reihenfolge von Mikrovertiefungen aufweisenden Tragauflage (1) ;
umfaßt.

11. Verfahren gemäß irgendeinem der Ansprüche 8 bis 10, dadurch gekennzeichnet, daß der Werkstoff (9) Titannitrid ist.

12. Verfahren gemäß irgendeinem der Ansprüche 8 bis 11, dadurch gekennzeichnet, daß das Lichtstrahlenbündel (3) ein Laserstrahlenbündel ist, die Beseitigung der lichtempfindlichen Substanz (2) durch Beizen oder durch Sauerstoffplasmaätzen durchgeführt wird und daß die Übertragung der Information durch ein chemisches Ätzungsverfahren oder durch ein Ätzungsverfahren mit reaktivem Plasma stattfindet.

13. Verwendung der Urplatte gemäß irgeneinem der Ansprüche 1 bis 7 und/oder der mit dem Verfahren gemäß einem der Ansprüche 8 bis 12 für die Herstellung einer Matrize zur Prägung von optischen Platten erhaltenen Urplatte.
